Europäisches Patentamt

European Patent Office

Office européen des brevets

(11) Veröffentlichungsnummer: **0 241 024**
**B1**

# (12) EUROPÄISCHE PATENTSCHRIFT

(45) Veröffentlichungstag der Patentschrift:
**11.10.89**

(21) Anmeldenummer: **87105232.0**

(22) Anmeldetag: **08.04.87**

(51) Int. Cl.⁴: **B65G 47/14, H01L 21/00**

(54) Haltevorrichtung zum Aufnehmen, Transportieren und Ablegen von Kleinbauteilen.

(30) Priorität: **08.04.86 DE 3611789**

(43) Veröffentlichungstag der Anmeldung:
**14.10.87 Patentblatt 87/42**

(45) Bekanntmachung des Hinweises auf die Patenterteilung:
**11.10.89 Patentblatt 89/41**

(84) Benannte Vertragsstaaten:
**AT BE CH DE ES FR GB GR IT LI LU NL SE**

(56) Entgegenhaltungen:
**DE-U- 8 514 640**
**GB-A- 925 381**
**GB-A- 1 243 283**
**US-A- 3 095 229**
**US-A- 3 424 486**

**TECHNICAL DIGEST/WESTERN ELECTRIC, Nr. 72,**
**Oktober 1983, Seiten 1,2, New York, US; B.C.**
**ABRAHAM: "Pick-up tool"**
**PATENT ABSTRACTS OF JAPAN, Band 9,**
**Nr. 146 (M-389)[1869], 21. Juni 1985; &**
**JP-A-60 23 217 (TETSUYA NAGAO) 05-02-1985**

(73) Patentinhaber: **Wilhelm Sedlbauer GmbH,**
**Wittelsbacherstrasse 2-8, D-8352 Grafenau(DE)**

(72) Erfinder: **Muscher, Siegfried, Wittelsbacherstrasse 16,**
**D-8352 Grafenau(DE)**
Erfinder: **Dankesreiter, Franz, Eisenthal-Siedl. 8,**
**D-8352 Grafenau(DE)**
Erfinder: **Dankesreiter, Franz, Jr., Badstrasse 48,**
**D-8351 Neuschönau(DE)**
Erfinder: **Band, Manfred, Kupfersgarten 12,**
**D-8501 Cadolzburg(DE)**

(74) Vertreter: **Seibert, Rudolf, Dipl.-Ing. et al,**
**Tattenbachstrasse 9, D-8000 München 22(DE)**

**Beschreibung**

Die vorliegende Erfindung bezieht sich auf eine Haltevorrichtung zum Aufnehmen, Transportieren und gezieltem Ablegen von Kleinbauteilen in einem Aufbau gemäß dem Oberbegriff des Patentanspruches 1.

Es besteht Bedarf an derartigen Haltevorrichtungen insbesondere beim Bestücken von Schaltungsträgerplatten - Leiterplatten -, wenn die einzelnen Bauelemente aus einem Behälter mit einer Vielzahl gleichartiger Bauelemente entnommen und auf die Leiterplatte dann definiert in einer durch die Verdrahtung auf der Leiterplatte vorgesehenen Lage und Richtung nach einem genau vorgegebenen Programm aufgebracht werden müssen, wo sie dann mit ihren Anschlüssen verlötet werden.

In jüngster Zeit sind nun Miniaturbauelemente, insbesondere SMD (Surface Mounted Devices)-Schaltelemente bekannt geworden, bei denen die übliche Arbeitsweise mit Hand nicht mehr möglich ist und die auch nicht mehr, wie elektrische Bauelemente früher, mit konkreten Drahtanschlüssen versehen sind, die vom Bauelement wegstehen und die dann entsprechend leicht verlötet werden können. Diese Miniaturbauelemente sind im allgemeinen stirnkontaktiert und ein Verlöten eines zwischen Fingern gehaltenen Bauelementes scheidet von vornherein aus. Der Einsatz von Pinzetten ist äußerst zeitaufwendig, da das Aufnehmen einzelner Bauelemente aus Behältern mit einer Pinzette im allgemeinen nicht die richtige räumliche Zuordnung zwischen Halterung (Pinzette) und Bauteil ermöglicht.

Es sind schon eine Reihe von Aufnahmegriffel oder Pipetten vorgeschlagen worden, die im allgemeinen aus einem Haltekopf mit einem Haltestiel bestehen, wobei die einzelnen Bauelemente mittels Unterdruck an eine Saugöffnung im Haltekopf angesaugt und so übernommen werden. Nach Verbringung auf die Schaltungsplatte werden die Bauelemente dann durch Wegnahme des Unterdruckes abgesetzt.

Eine Möglichkeit die Unterdruckquelle, die im allgemeinen über eine Anschlußschlauch durch das Griffteil hindurch bis zum Haltekopf und dessen Austrittsöffnung verbunden ist, zu betätigen, ist, einen Fußschalter vorzusehen, über den die Unterdruckquelle ein- und ausgeschaltet wird. Dabei muß Hand- und Fußbewegung genau koordiniert werden. Da das Aufsetzen eines Miniaturbauteils auf eine Schaltungsplatte höchste Konzentration erfordert, stört die Bedienungsperson die zusätzliche Bewegung mit dem Fuß, wobei es auch leicht zu Erschütterungen kommt, und zwar genau in dem Moment, in welchem das Bauteil abgesetzt werden soll, wodurch das Bauteil unter Umständen verschoben und dann falsch verlötet werden kann.

Auch Unterdruckaufbau und -abbau ist bei dieser Art von Handgeräten für viele Zwecke zu langsam.

Es sind auch schon Haltevorrichtungen für die erwähnten Bauteile bekannt geworden, bei denen der Druckaufbau und -abbau über einen Schalter im Handgriff bzw. ein Entlüftungsloch, das von einem Finger der Bedienungsperson geöffnet oder geschlossen wird, betätigt werden. Derartige Ausbildungen zeigen beispielsweise die US-A 3 095 229 oder die DE-U 8 514 640. Auch hier ist der Nachteil gegeben, daß durch die Betätigung eines Schalters im Stiel zusätzliche Erschütterungen entstehen können, die ein einwandfreies Absetzen der Kleinbauteile erschweren.

Außerdem ist zu berücksichtigen, daß die räumliche Zuordnung zwischen Bauelement und Leiterplatte in Richtung erfolgen kann, die bis zu 180° voneinander abweichen. Die Bedienungsperson muß dabei den Haltegriff ebenfalls verschieden in die Hand nehmen bzw. die Hand verdrehen, was eine Betätigung eines Schalters am Handgriff äußerst erschweren kann.

Aufgabe der Erfindung ist es eine Haltevorrichtung für Kleinbauteile, also insbesondere elektrische Kleinstbauelemente anzugeben, bei dem ein Aufnehmen und Ablegen der Bauelemente von der Bedienungsperson keine zusätzlichen Schaltmaßnahmen erfordert, sondern durch einfaches Heranführen der Haltevorrichtung an das Bauelement bzw. zusammen mit dem Bauelement an die gewünschte Ablegestelle selbsttätig erfolgt.

Diese Aufgabe wird mit einer Haltevorrichtung mit den Merkmalen des Patentanspruches 1 gelöst. Vorteilhafte Ausgestaltungen ergeben sich aus den Unteransprüchen.

Bei der Haltevorrichtung nach der Erfindung ist der Haltekopf, der an seiner Vorderseite das Bauelement halten soll und von dem das Bauelement dann wieder abgegeben wird, zweiteilig ausgeführt, wobei die beiden Teile gegen eine Federkraft teleskopartig in gewissen Umfang verschieblich sind. Dabei ist ein bistabiles Umschaltglied vorgesehen, das bei jedem Druck auf die Spitze des Haltekopfes selbst einmal umgeschaltet wird und umgeschaltet bleibt, auch wenn der Druck wieder abgenommen ist. Im Falle des Haltens der Bauelemente durch Unterdruck wird also bei einer Ausführungsform nach der Erfindung die Haltevorrichtung mit dem Haltekopf auf ein Bauelement gedrückt, wodurch über das bistabile Umschaltglied der Unterdruck eingeschaltet wird und eingeschaltet bleibt.

Beim Absetzen des Bauelementes auf der Leiterplatte wird durch den beim Aufsetzen sowieso entstehenden Druck ein neuer Impuls gegeben und das bistabile Umschaltglied schaltet den Unterdruck ab, so daß die griffelartige Haltevorrichtung unmittelbar abgenommen und zur Aufnahme eines weiteren Bauelementes geführt werden kann.

Es ist für den Fachmann ersichtlich, daß das erfindungsgemäß vorzusehende bistabile Umschaltglied auf verschiedene Weise - im übrigen je nach dem vorgesehen Anwendungszweck - ausgeführt werden kann. Bei dem Einsatz der Erfindung in Verbindung mit Bestückungstischen, wo schon wegen des Lötvorganges elektrische Energie vorhanden ist, wird man als bistabiles Umschaltglied eine elektrische Kippstufe vorsehen, die über im Haltekopf angeordnete Kontakte wie bei einem Primärzähler immer wieder umgeschaltet wird und über ein Magnetventil oder dergleichen Unterdruckzufuhr ein- und ausschaltet.

Im Rahmen der Erfindung können aber auch beliebig andere bistabile Umschaltglieder, z.B. auch einfache Schnappfedern vorgesehen werden, die dann bei einem Anstoß einmal in die eine Richtung und beim nächsten Anstoß in die andere Richtung umschnappen und dabei entweder eine Saugöffnung verschließen oder freigeben oder aber einen Abstreifstift oder dergleichen vor- und zurückschieben, wie noch in Verbindung mit einem Ausführungsbeispiel erläutert werden wird. Dies ist gemäß einer vorteilhaften Weiterbildung des Erfindungsgedankens dann von besonderem Vorteil, wenn das einzelne Bauelement an einem an der Spitze des Haltekopfes vorzusehenden Adhäsionsüberzug oder -pfropfen gehalten wird und durch den Pfropfen bzw. den Überzug ein Abstreifstift rein- und rausschiebbar geführt ist, der dementsprechend durch ein mechanisches Umschaltglied, wie es beispielsweise auch bei Kugelschreibern usw. eingesetzt wird, im Sinne der Erfindung betätigt wird.

Aufbau einer Haltevorrichtung wird im folgenden in Zusammenfassung und in Verbindung mit der anliegenden Zeichnung erläutert. In den Zeichnungen zeigen:

Fig. 1 Grundaufbau einer Haltevorrichtung nach der Erfindung in Form einer Saugpipette,

Fig. 2 den Grundaufbau einer praktischen Realisierungsmöglichkeit,

Fig. 3 den Einsatz eines Adhäsionspfropfens in Verbindung mit einem Haltekopf und

Fig. 4 eine Ausführungsmöglichkeit für eine Haltevorrichtung zur Übernahme von Bauteilen, die durch Anpicksen gehalten werden können.

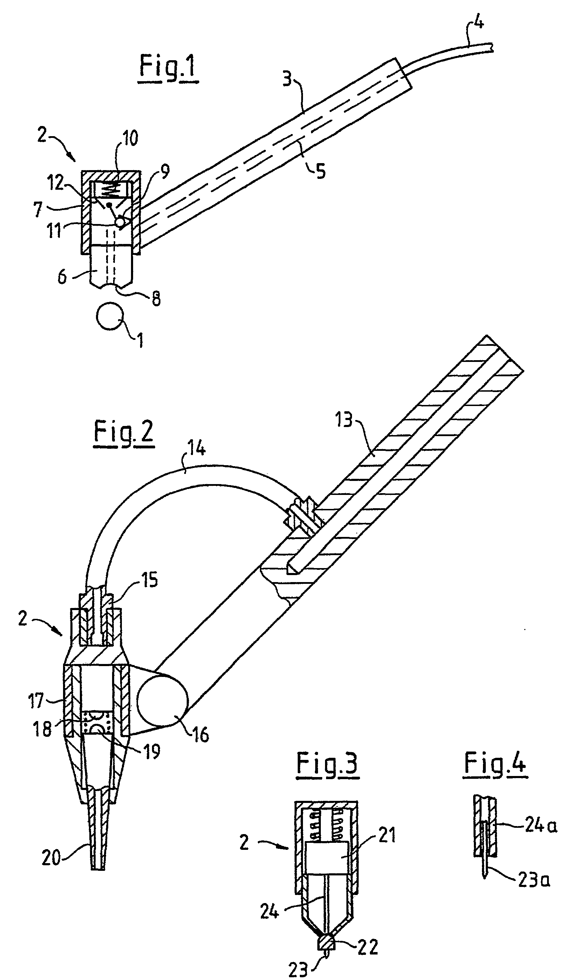

Anhand der Fig. 1 wird zunächst die Erfindung nochmals im Zusammenhang erläutert. Dabei wird davon ausgegangen, daß ein zylinderförmiges SMD-Schaltelement 1 beim Annähern einer aus einem Haltekopf 2 mit Haltestiel 3 bestehenden Haltevorrichtung durch Unterdruck angesaugt werden soll. Dabei ist der Haltekopf 2 in seinem vorderen Bereich dem Bauelement 1 insoweit angepaßt, daß der über die Zuleitung 4 und Innenführung 5 im Stiel 3 von einem Unterdruckerzeuger aufgebaute Unterdruck voll abgedichtet wird und dadurch das Bauelement 1 hält.

Entsprechend dem Vorschlag nach der Erfindung ist der Haltekopf zweiteilig ausgeführt, wobei der vordere Gleitteil 6 mit der Ansaugöffnung 8 gegen Druck einer Feder 10 nach innen geschoben werden kann. Hierzu ist das mit dem Stiel 3 festverbundene starre Teil 7 als Führung ausgebildet.

Im Inneren des Haltekopfes ist ein Kugelventil 9 angedeutet, das über eine mechanische Wippe 11 zwei verschiedene Stellungen einnehmen kann, wobei in der gezeichneten Lage der Unterdruck unterbunden sein soll, während bei einem Umschnappen nach links die Kugel die Saugöffnung freigeben würde. Um diese Schnappwippe 11 hin- und herzusteuern sind zwei Steuerstifte 12 vorgesehen, die das Umschalten der Schnappwippe immer dann auslösen, wenn das Vorderteil kurz nach hinten gedrückt wird.

In dem dargestellten Fall wäre nun in der Leitung 5 im Haltestiel 3 Unterdruck vorhanden und die Ventilkugel 9 in der dargestellten Lage, so daß an der Saugöffnung 8 keinerlei Sauggeräusch zu hören ist und auch keine Luft angesaugt wird.

Wird die gesamte Vorrichtung auf das Bauelement 1 gebracht und dort ein gewisser Druck ausgeübt, was unmittelbar möglich ist, da das Bauelement ja in einem Behälter entweder am Boden oder auf anderen Bauelementen liegt, dann wird der Kopf 6 nach innen gedrückt und der rechte der Steuerstift 12 würde die Schaltwippe 11 nach links drücken, wo sie stabil stehen bleibt, auch wenn der Kopf wieder aufgrund der Gegenkraft der Feder 10 nach unten gedrückt wird. Die Kugel 9 gibt den Saugweg frei und der Unterdruck entsteht an der Ansaugöffnung 8.

Die Haltevorrichtung kann dann mit dem Bauelement 1 beliebig bewegt werden und, wenn die Bedienungsperson dann das Bauelement 1 auf einer Leiterplatte (nicht gezeigt) absetzt und kurz einen Druck ausübt, der für das einwandfreie Auflegen des Bauelementes auf der Leiterplatte sowieso notwendig ist, schaltet der linke Steuerstift die Schaltwippe 11 wieder um und die Saugöffnung ist verschlossen, so daß die gesamte Haltevorrichtung von dem Bauelement 1, da diese sich auf der Leiterplatte befindet und dort verlötet wird, unmittelbar abgehoben werden kann. Nun ist bis zum Aufsetzen der Haltevorrichtung auf das nächste Bauelement an der Saugöffnung keinerlei Unterdruck vorhanden.

Das Prinzip der Erfindung wurde zunächst anhand der Fig. 1 bewußt sehr schematisch und ohne konstruktive Details erläutert, da es zur Realisierung der aufgezeigten Funktion eine Vielzahl von konstruktiven Maßnahmen gibt, die dem Fachmann geläufig sind. Es sei dabei nur an die Vielzahl der in Verbindung mit Kugelschreibern bekannten Umschaltvorrichtungen verwiesen, die auf einen Druck die Schreibspitze nach außen führen, dort stabil halten und auf den nächsten Druck den Stift wieder zurückschnappen lassen, ohne daß er wieder nach vorne fällt.

Die Fig. 2 zeigt in einer etwas detaillierten Form den Aufbau einer Haltevorrichtung nach der Erfindung in Form einer Saugpipette. Bei der dargestellten Ausführungsform wird der Schlauch mit dem Unterdruck aus dem Handgriff 3 herausgeführt und von oben in den widerum zweiteiligen Haltekopf 2 geführt. Dabei ist der Schlauch 14 luftdicht drehbar im oberen Ansatz des Haltekopfes 2 geführt, um eine beliebige räumliche Zuordnung des Haltestieles 3 zum Haltekopf 2 zu ermöglichen. Hierzu ist einmal ein Schaniergelenk 16 vorgesehen, das die Einstellung eines beliebigen Winkels des Haltestieles 3 zur Achse des Haltekopfes 2 ermöglicht.

Diese Scharnier 16 ist an einer Hülse 17 befestigt. Die Hülse 17, deren Achse mit der Mittellinie des Haltekopfes 2 zusammenfällt, ist frei drehbar in dem Haltekopf 2 gelagert, so daß auch insoweit der Haltestiel um den Haltekopf 2 herumgedreht werden kann.

Bei der dargestellten Ausführungsform ist die Saugrohrspitze 20 auswechselbar dargestellt.

Das - nicht gezeigte - Umschaltglied wird bei der vorgesehenen Ausführungsform elektrisch gesteuert, und zwar über die elektrischen Kontakte 18 und 19, die durch eine nur angedeutete Feder auseinander gedrückt werden.

Es ist auch aus dieser Darstellung ersichtlich, daß durch einen geringen Druck auf die Saugspitze 20 des Kopfes 2 nach oben z.B. mit Hilfe des Haltestieles 13 sich die beiden Kontakte berühren und einen Stromkreis herstellen, der ein bistabiles Kippglied dann entsprechend umschaltet, das seinerseits wiederum das Ein- und Ausschalten des Unterdruckes auslöst.

Anhand der Fig. 3 wird im folgenden nur angedeutet, daß die Haltevorrichtung nach der Erfindung auch ohne Anschluß an eine Saugquelle realisiert werden kann. Dabei ist in der Fig. 3 lediglich der Haltekopf ohne Haltestiel schematisch angedeutet, der wiederum zweiteilig ausgeführt ist. Im Gegensatz zu den vorbeschriebenen Ausführungsformen ist an der Spitze des Haltekopfes ein Pfropfen aus einem adhäsiven Material, an welchem ein Bauelement mit ausreichender Kraft für einen Transport haften bleibt.

In diesem Fall ist ein mechanisch arbeitendes bistabiles Umschaltglied 21 vorgesehen, das - ähnlich wie bei einem Kugelschreiber - bei einem Druck die Abdrückstange 24 mit Spitze 23 zurückzieht oder beim nächsten Druck durch den Pfropfen 22 nach vorne schiebt.

Wird eine Haltevorrichtung mit einem derartigen Kopf auf ein Bauelement aufgedrückt, schiebt sich die Spitze 23 in dem Pfropfen 22 zurück und bleibt dort abhängig von dem bistabilen Umschaltglied 21 in zurückgezogenem Zustand, so daß das Bauelement unmittelbar an dem adhäsiven Haltekopf 22 kleben bleibt. Beim Aufsetzen des dann transportierten Bauelementes auf eine Leiterplatte wird wiederum - wie schon erläutert - ein kurzer Druck ausgeübt, wodurch die Spitze 23 des Stiftes 24 nach vorne kommt und das Bauelement von der Klebeoberfläche wegdrückt.

Bei der Erläuterung der Erfindung wurde immer davon ausgegangen, daß konkrete SMD-Schaltelemente, für die die Erfindung in besonderer Weise geeignet ist, aufgenommen, transportiert und abgelegt werden sollen. Das Prinzip der Erfindung ist auch bei anderen Kleinteilen, beispielsweise kleineren Zwischenlagen, Blättchen und dergleichen einsetzbar. Sofern Teile aufgenommen werden sollen, die beispielsweise aus Papier oder einem anderen weichen Stoff betsehen, dann kann anStelle eines adhäsiven Pfropfens auch einfach ein kleiner Pickser vorgesehen werden, der in einer Hülse geführt ist, wobei die Hülse abhängig von einem bistabilen Umschaltglied entweder über die Spitze vorgeschoben oder so zurückgezogen wird, daß mit der Spitze das Papierblättchen oder dergleichen aufgenommen werden kann. Dies ist anschaulich in Fig. 4 in einem Ausschnitt gezeigt, wo eine Spitze 23 a die dem Abstreifer in Fig. 3 entsprechen kann, in einer Hülse 24 a geführt ist, die dem Stab 24 entspricht und entweder nach vorne geschoben oder, wie dargestellt, zurückgezogen ist. Beim Vorschieben würde dann ein aufgenommenes Kleinelement abgestreift und könnte so abgestreift werden.

Für den auf dem Sachgebiet tätigen Fachmann sind noch weitere Abwandlungen möglich, wobei in jedem Fall darauf zu achten ist, daß durch einen einfachen Druck auf die Haltespitze selbst, gleichgültig ob dort eine Saugöffnung oder eine andere Haftmöglichkeit vorhanden ist, ein bistabiles Umschaltglied jeweils umgeschaltet wird.

**Patentansprüche**

1. Haltevorrichtung bestehend aus Haltekopf (2) und Haltestiel (3) zum Aufnehmen, Transportieren und gezieltem Ablegen von Kleinbauteilen (1), vorzugsweise zum Bestücken von Schaltungsträgerplatten mit elektrischen Kleinbauteilen, wie SMD-Schaltelementen, wobei die einzelnen Bauteile einzeln aus einer eine Vielzahl gleichartiger Bauteile enthaltenden Aufnahmebehälter aufgenommen und einzeln definiert, z.B. auf der Trägerplatte zur weiteren Behandlung, z.B. zum Kontaktieren, abgelegt werden, dadurch gekennzeichnet, daß im Haltekopf (2) ein durch einen Anpreßdruck des Haltekopfes (2) auf eine Unterlage, z.B. auf ein Bauteil (1) auslösbares, bistabiles Umschaltglied (9, 11) vorgesehen ist, das bei einem ersten Druck das Aufnehmen des Kleinbauteiles ermöglicht und bei einem zweiten Druck das aufgenommene Kleinbauteil freigibt, bzw. abdrückt.

2. Vorrichtung nach Anspruch 1, dadurch gekennzeichnet, daß der Haltekopf (2) zweiteilig (6, 7) derart ausgeführt ist, daß ein unteres Aufnahmeteil (6) entgegen der Kraft einer Feder (10) in einem oberen Führungsteil zur Betätigung des bistabilen Umschaltgliedes (9, 11) verschiebbar ist.

3. Vorrichtung nach Anspruch 1, dadurch gekennzeichnet, daß die aufzunehmenden, zu transportierenden oder abzulegenden Kleinbauteile (1) in an sich bekannter Weise durch Ansaugen an dem Haltekopf gehalten sind und daß eine Schaltvorrichtung vorgesehen ist, die bei jedem Druck des Haltekopfes gegen die Unterlage über das bistabile Umschaltglied die Unterdruckquelle an- bzw. abschaltet.

4. Vorrichtung nach Anspruch 1, dadurch gekennzeichnet, daß im Haltekopf (2) zwei gegen Federkraft zueinander bewegbare Kontakte (18, 19) vorgesehen sind, über die bzw. eine dazwischen geschaltete elektrische Kippstufe Unterdruck zum Ansaugen der Bauelemente (1) an den Haltekopf (2) an- bzw. abgeschaltet wird.

5. Vorrichtung nach Anspruch 1, dadurch gekennzeichnet, daß im Haltekopf (2) ein mechanisch arbeitendes bistabiles Umschaltglied (21) vorgesehen ist, das durch einen an der Spitze des Haltekopfes vorgesehenen Adhäsionsüberzug (22) einen Abdrückstift (23) nach außen führt oder diesen zurückzieht.

6. Haltevorrichtung nach Anspruch 1, dadurch gekennzeichnet, daß zur Aufnahme von Kleinbauteilen (1) mit Hilfe einer Nadelspitze (23a) im Haltekopf (2) eine über die Spitze des Haltekopfes hinausgehende Nadelspitze (23a) vorgesehen ist, die von einem relativ zur Nadel bewegbaren Hülse (24a) umgeben ist, die abhängig von der Druckbewegung über die Nadel vorschiebbar und bei der nächsten Bewegung hinter die Nadelspitze zurückziehbar gelagert ist und die abhängig von einem mechanisch arbeitenden bistabilen Umschaltglied betätigbar ist.

## Revendications

1. Dispositif de préhension constitué par une tête de préhension (2) et un bras de préhension (3) pour saisir, transporter et déposer, de la manière souhaitée, des petits composants (1), de préférence pour équiper des plaquettes portant des circuits, avec des petites composants électriques, comme par exemple des éléments de circuit SMD, les différents composants étant prélevés individuellement d'un récipient récepteur contenant une multiplicité de composants identiques, et étant déposés d'une manière définie individuellement, par exemple sur la plaque de support, en vue de la poursuite du traitement, par exemple pour l'établissement de contacts, caractérisé par le fait que dans la tête de préhension (2) il est prévu un circuit de commutation bistable (9, 11), qui peut être déclenché par une pression appliquée par la tête de préhension (2) sur un support, par exemple sur un composant (1), permet la saisie du petit composant, sous l'action d'une première pression, et libère ou repousse le petit composant saisi, sous l'action d'une seconde pression.

2. Dispositif suivant la revendication 1, caractérisé par le fait que la tête de préhension (2) est formée de deux parties (6, 7), de telle sorte qu'une partie inférieure de réception (6) peut être repoussée à l'encontre de la force d'un ressort (10) dans une partie supérieure de guidage, pour réaliser l'actionnement du circuit de commutation bistable (9, 11).

3. Dispositif suivant la revendication 1, caractérisé par le fait que les petits composants (1), qui doivent être saisis, transportés ou déposés, sont retenus de façon connue en soi par aspiration au niveau de la tête de préhension et qu'il est prévu un dispositif de commutation qui, chaque fois que la tête de préhension applique une pression contre le support, raccorde ou débranche la source de dépression par l'intermédiaire du circuit de commutation bistable.

4. Dispositif suivant la revendication 1, caractérisé par le fait que dans la tête de préhension (2) il est prévu deux contacts (18, 19), qui peuvent être déplacés l'un par rapport à l'autre à l'encontre de la force d'un ressort, ces contacts ou un étage à bascule électrique intercalé appliquant ou interrompant la dépression servant à aspirer les composants (1) contre la tête de préhension (3).

5. Dispositif suivant la revendication 1, caractérisé par le fait que dans la tête de préhension (2) il est prévu un circuit de commutation bistable (21) à action mécanique, qui fait ressortir un poussoir (23) ou le rétracte, à travers un revêtement adhésif (22) prévu sur la pointe de la tête de préhension.

6. Dispositif de préhension suivant la revendication 1, caractérisé par le fait que pour la saisie de petits composants (1) à l'aide d'une pointe d'aiguille (23a), il est prévu, dans la tête de préhension (2), une telle pointe d'aiguille (23a), disposée en saillie au-delà de la pointe de la tête de préhension et entourée par une douille (24a), qui est déplaçable par rapport à l'aiguille, peut être avancée par rapport à cette dernière en fonction du déplacement sous pression, est montée de manière à pouvoir être rétractée en arrière de la pointe de l'aiguille, lors du déplacement immédiatement suivant et peut être actionnée en fonction d'un circuit de commutation bistable à action mécanique.

## Claims

1. A holder device comprising a holder head (2) and holder handle (3) for picking-up, transporting and purposively depositing micro-components (1), especially for the assembly of circuit carrier boards with electrical micro-components such as SMD - circuit elements, where the individual components are picked up individually from a container containing a plurality of identical components and are deposited in an individually defined fashion, e.g. on the carrier board, for further processing, for example, for contacting, characterised in that in the holder head (2), there is provided a bistable switch-over element (9, 11) which can be triggered by pressure of the holder head (2) against a base, e.g. a component (1), and which, in response to a first pressure, allows the micro-component to be picked-up and, in response to a second pressure, releases or expels the micro-component which has been picked-up.

2. A device as claimed in Claim 1, characterised in that the holder head (2) is designed to consist of two parts (6, 7), in such manner that a lower receiving part (6) can be displaced against the force of a spring (10) in an upper guide section in order to actuate the bistable switch-over element (9, 11).

3. A device as claimed in Claim 1, characterised in that the micro-components which are to be picked-up, transported or deposited, are held in contact with the holder head by suction in known manner, and that a switching device is provided which, whenever the holder head is pressed against the base, switches the vacuum source on or off through the bistable switch-over element.

4. A device as claimed in Claim 1, characterised in that in the holder head (2) there are provided two contacts (18, 19) which can be moved towards one another against a spring force and via which or via an interposed electrical trigger stage, vacuum which brings the components (1) into suction contact with the holder head (2), is switched on or off.

5. A device as claimed in Claim 1, characterised in that in the holder head (2) there is provided a mechanically operating, bistable switch-over element (21) which either expels or retracts an ejector pin (23, through an adhesive coating (22) provided at the tip of the holder head.

6. A holder device as claimed in Claim 1, characterised in that in order to pick up micro-components (1) by means of a needle point (23a) in the holder head (2), a needle point (23a) is provided which extends beyond the tip of the holder head and which is surrounded by a sleeve (24a) which is movable in relation to the needle and which is so mounted that, in dependence upon the pressing movement, it can be moved forwards over the needle and, with the next movement, retracted behind the needle point and which can be actuated in dependence upon a mechanically operating, bistable switch-over element.

Fig.1

Fig.2

Fig.3

Fig.4